# EUROPEAN PATENT APPLICATION

(11) **EP 4 451 316 A1**
(43) Date of publication of application: **23.10.2024**
(21) Application number: 22915777.1
(22) Date of filing: 16.12.2022
(51) Int. Cl.: H01L 21/677, H01L 21/304

(54) **SUBSTRATE TRANSFER DEVICE AND SUBSTRATE TRANSFER METHOD**

(30) Priority: 28.12.2021 JP 2021214779
(71) Applicant: Shibaura Mechatronics Corporation, Yokohama-shi, Kanagawa 247-8610 (JP)
(72) Inventor: ARAI, Rie, Yokohama-shi, Kanagawa 247-8610 (JP); NISHIBE, Yukinobu, Yokohama-shi, Kanagawa 247-8610 (JP); KATO, Shun, Yokohama-shi, Kanagawa 247-8610 (JP); FUTATSUKAWA, Shinji, Yokohama-shi, Kanagawa 247-8610 (JP)
(74) Representative: Kramer Barske Schmidtchen Patentanwälte PartG mbB
(86) International application number: PCT/JP2022/046444
(87) International publication number: WO 2023/127553

(57) **Abstract**

A substrate delivery apparatus and a substrate delivery method that can maintain a wet surface of a substrate and transport the substrate between processing devices are provided. A substrate delivery apparatus 2 of the present embodiment includes: a cart housing 210 having a housing room 211 that receives from outside and houses the substrate transportation cart 1 in which a tank 110 containing a plurality of substrates W and water is loaded; and a take-out device 250 that takes the substrate W out from the tank 110 loaded in the substrate transportation cart 1 housed in the housing room 211 and delivers the substrate W to the washing apparatus 3 that is the adjacent processing device.

## Description

### FIELD OF INVENTION

The present disclosure relates to a substrate delivery apparatus and a substrate delivery method.

### BACKGROUND

In a manufacturing method to manufacture semiconductors, after the surfaces of substrates such as wafers are polished by polishing apparatuses (CMP apparatuses), slurry formed by abrasives used in polishing are washed by washing apparatuses. Common washing apparatuses are installed adjacent to the polishing apparatus, and the substrates are transported from the polishing apparatus to the washing apparatus by transporting apparatus (refer Patent Document 1).

Here, the slurry used in the above CMP polishing process remains on the surface of the substrate right after washing. This slurry sticks to the surface of the substrate when dried and cannot be removed by the washing apparatus afterward. Therefore, the polishing apparatus and the transporting apparatus are installed adjacent to each other, and the transporting apparatus such as robots transports the substrate with the surface thereof wetted by liquid, so that the surface of the substrate will not be dried.

### PRIOR ART DOCUMENT

### PATENT DOCUMENT

Patent Document 1: JP4451429

### SUMMARY OF INVENTION

### PROBLEMS TO BE SOLVED BY INVENTION

However, due to constraints of spaces and layouts in the factory, various processing apparatuses to process the substrate may have to be installed separately. For example, when the polishing apparatus and the washing apparatus are installed separately, the substrate cannot be transported by the robot, and the workers must transport them. However, as described above, when the substrate is transported, the surface of the substrate must be kept wet. Even if the substrate is immersed in the tank filled with water, it is necessary to provide means to transport the tank to the washing apparatus, take out the substrate from the tank, and carry the substrate into the washing apparatus.

Objective of embodiments of the present disclosure is to provide a substrate delivery apparatus and a substrate delivery method that can keep a wet surface of a substrate and deliver the substrate between processing devices.

### MEANS TO SOLVE THE PROBLEM

A substrate delivery apparatus of the embodiment of the present disclosure includes: a cart housing having a housing room that receives from outside and houses a substrate transportation cart in which a tank containing a plurality of substrates and liquid is loaded; and a take-out device that takes the substrate out from the tank loaded in the substrate transportation cart housed in the housing room and delivers the substrate to an adjacent processing device.

### EFFECT OF INVENTION

Embodiments of the present disclosure can provide a substrate delivery apparatus and a substrate delivery method that can maintain a wet surface of a substrate and transport the substrate between processing devices.

### BRIEF DESCRIPTION OF DRAWINGS

Fig. 1 is a front perspective view illustrating the substrate transportation cart and the substrate delivery apparatus according to the embodiment.
Fig. 2 is a back perspective view illustrating the substrate delivery apparatus according to the embodiment.
Fig. 3 is a partially cross-sectional front perspective view illustrating the substrate delivery apparatus according to the embodiment.
Fig. 4 is a partially cross-sectional back perspective view illustrating the substrate delivery apparatus according to the embodiment.
Fig. 5 is a plan view illustrating the substrate transportation cart housed in the housing room.
Fig. 6 is a cross-sectional side view illustrating the cassettes housed in the tank.
Fig. 7A is a front perspective view illustrating the substrate transportation cart, and Fig. 7B is a back perspective view illustrating the substrate transportation cart.
Fig. 8A is a partially cross-sectional front perspective view illustrating the tank of the substrate transportation cart, and Fig. 8B is a partially cross-sectional back perspective view illustrating the tank of the substrate transportation cart.
Fig. 9 is a perspective view illustrating the driving coupler.
Fig. 10A is a bottom view illustrating the substrate transportation cart, and Fig. 10B is a bottom perspective view illustrating the substrate transportation cart.
Fig. 11 is a front perspective view illustrating the housing room in the docking module.
Fig. 12 is a plan view illustrating the separation mechanism in the housing room.
Fig. 13 is a partially cross-sectional back perspective view illustrating the drainage.
Fig. 14A is a front perspective view illustrating the substrate transportation cart housed in the housing room, and Fig. 14B is a back perspective view illustrating the substrate transportation cart housed in the housing room.
Fig. 15A is a front perspective view illustrating the cutting out operation of the substrate by the take-out device, and Fig. 15 B is a back perspective view illustrating the cutting out operation of the substrate by the take-out device.
Fig. 16(a) is a partial cross-sectional back perspective view illustrating the washer, Fig. 16(b) is a partial cross-sectional side view illustrating the washer, and Fig. 16(c) is a partial cross-sectional side view illustrating the washer in a spraying state.
Fig. 17 is a perspective view illustrating an appearance of the washer.
Fig. 18 is a front view illustrating the wind blower.

### EMBODIMENTS

Hereinafter, embodiments of the present disclosure will be described referring to the figures.

### [Summary]

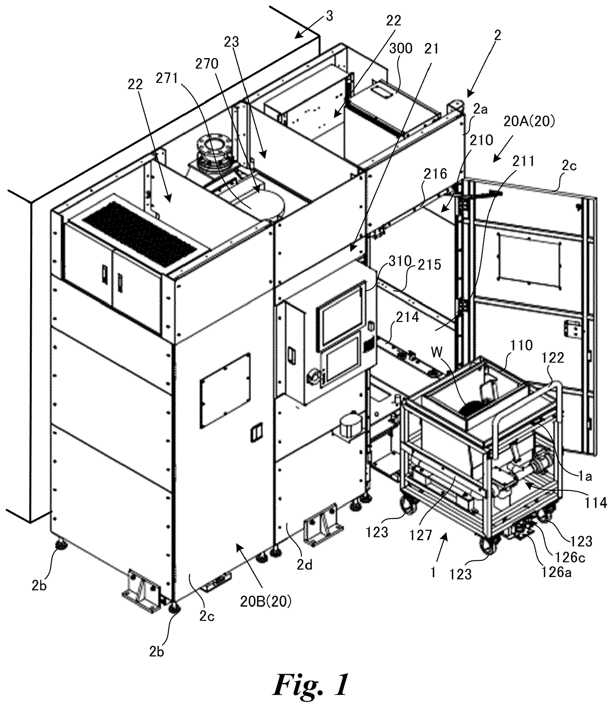

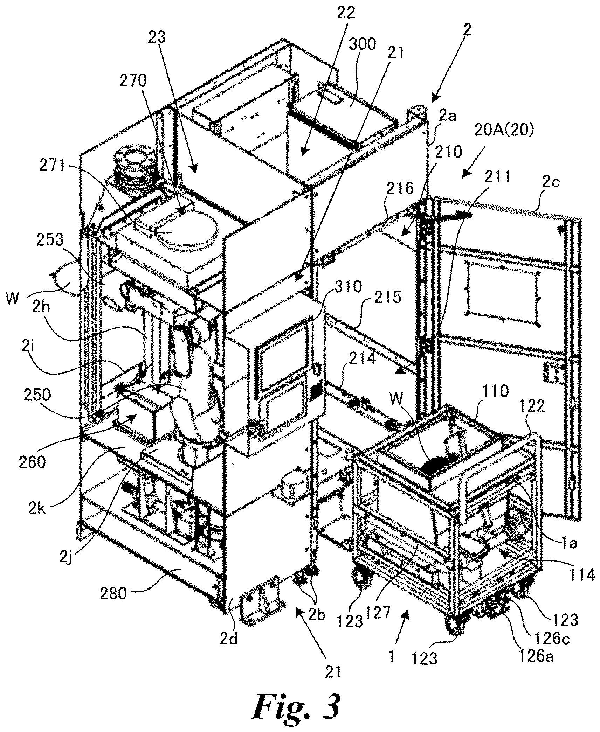

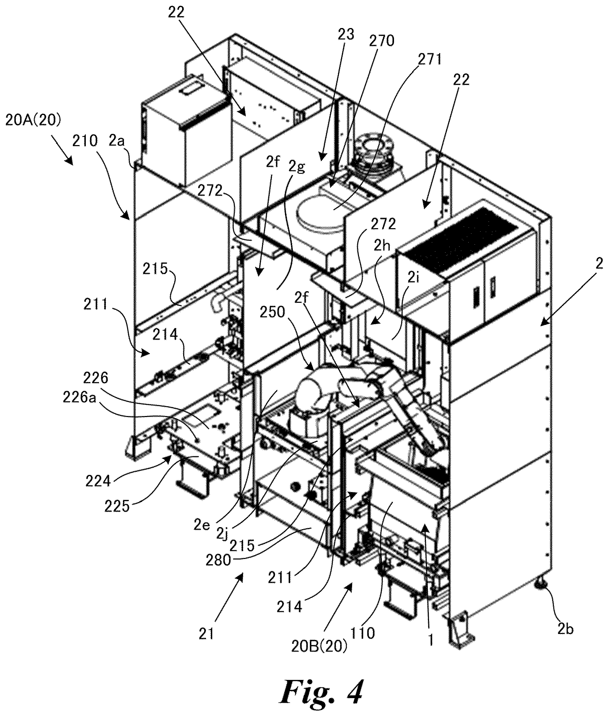

As illustrated in Figs. 1 to 3, a substrate transportation cart 1 of the embodiment is a cart for workers to transport a substrate W between a polishing apparatus (unillustrated) and a substrate delivery apparatus 2. As illustrated in Figs. 3 and 4, the substrate delivery apparatus 2 of the embodiment is an apparatus that delivers the substrate W from a substrate transportation cart 1 to a washing apparatus 3. The washing apparatus 3 is an apparatus that washes a surface of the substrate W by a brush, while supplying processing liquid for washing on the surface of the substrate W which has been polished by a polishing apparatus.

In the description below, in the substrate delivery apparatus 2, a side where the substrate transportation cart 1 is carried in is referred to as the front side, and a side where the substrate W is delivered to the washing apparatus 3 is referred to as the back side. As for the substrate transportation cart 1, when the worker carries in the substrate delivery apparatus 2, the rear side is the back side and the front side is the front side. The front side may be referred to as the front face, and the back side may be referred to as the back face.

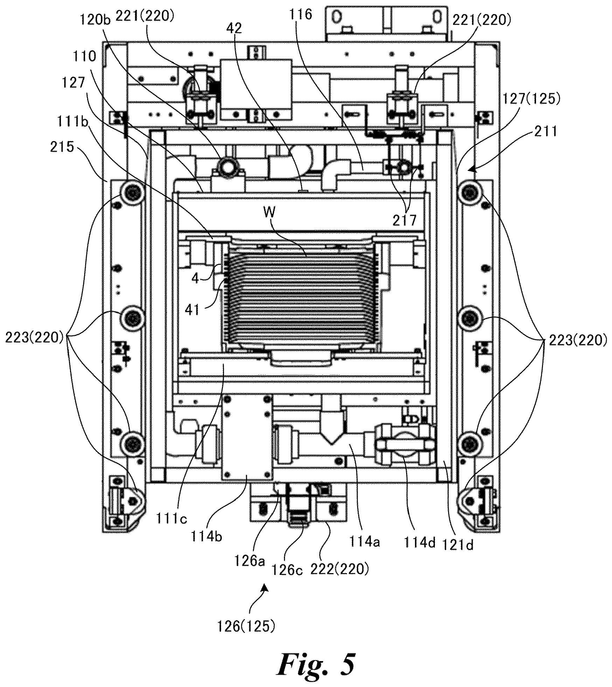

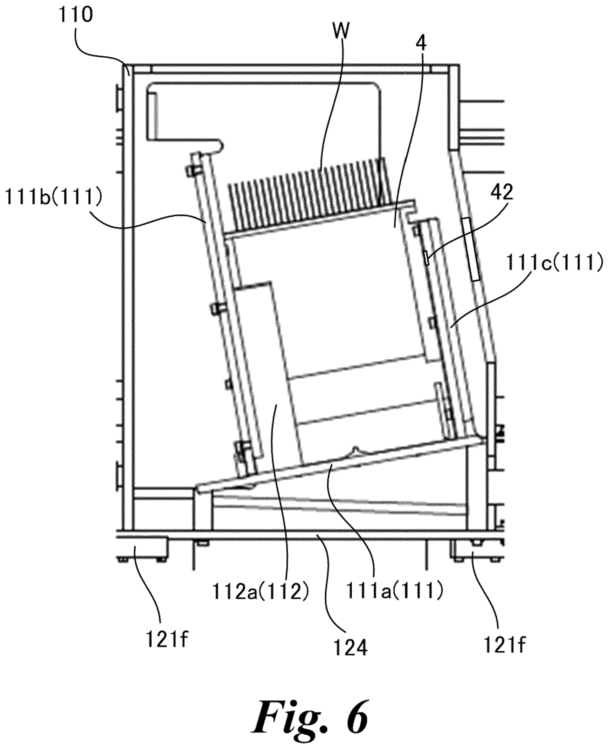

As illustrated in Figs. 5 and 6, a plurality of the substrates W polished in the polishing apparatus are stacked and housed with a certain gap between each other in a box-shaped cassette (FOUP) 4, The cassette 4 includes a casing having a space for housing the substrate therein, and a partition 41 provided to face the inner wall of the casing and supporting the substrate near the end, and a spacing is maintained between the plurality of the substrate W in the cassette 4 by the partition. The cassette 4 includes a pair of the inner wall provided to face a pair of the partition, and a pair of walls connected to the pair of the inner wall and facing the main surface of the stacked and housed substrate W, and a portion of the cassette 4 facing the peripheral end surface of the stacked substrate W is opened. Furthermore, the cassette 4 is marked with identification information 42 to identify each cassette 4. For example, the identification information 42 is a bar code and 2D code. Note that, for example, the substrate W transported by the present embodiment is a semiconductor wafer, however, it is not limited thereto and may be any substrate that needs to be transported while immersed in liquid.

### [Substrate Transportation Cart]

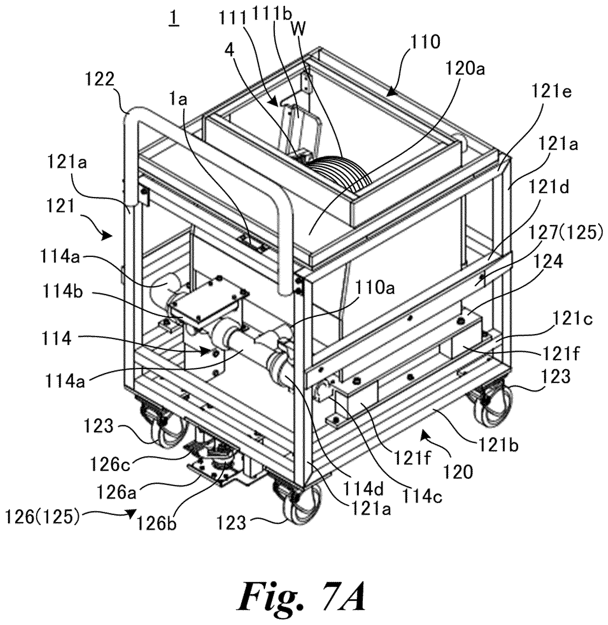

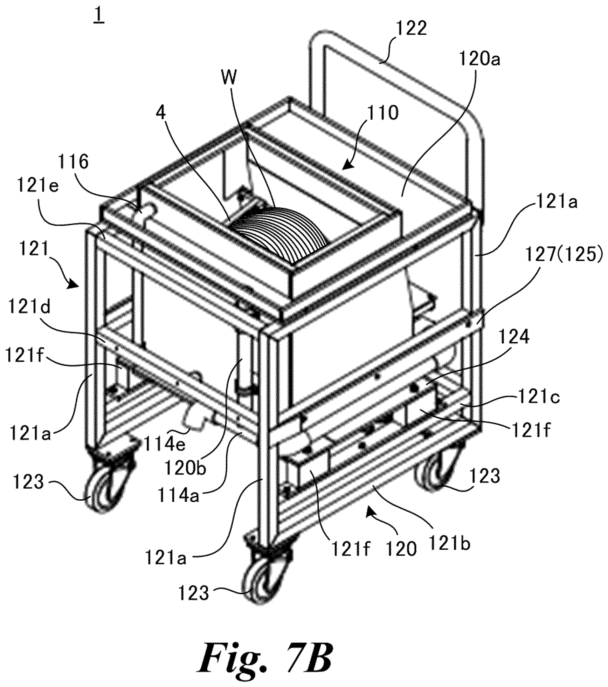

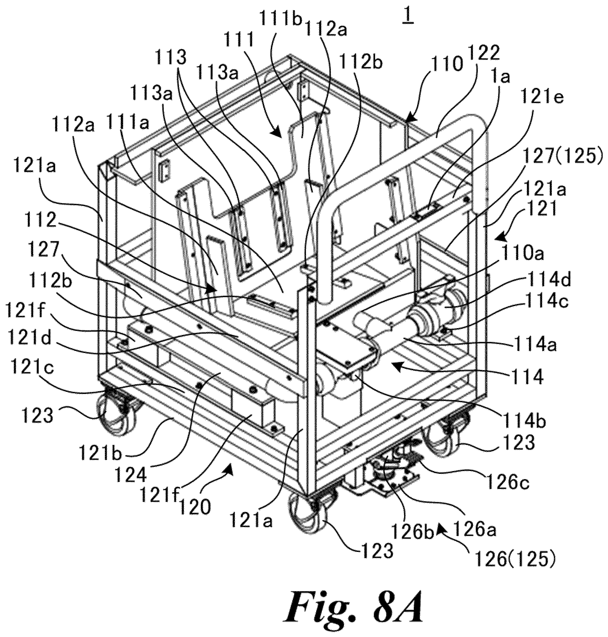

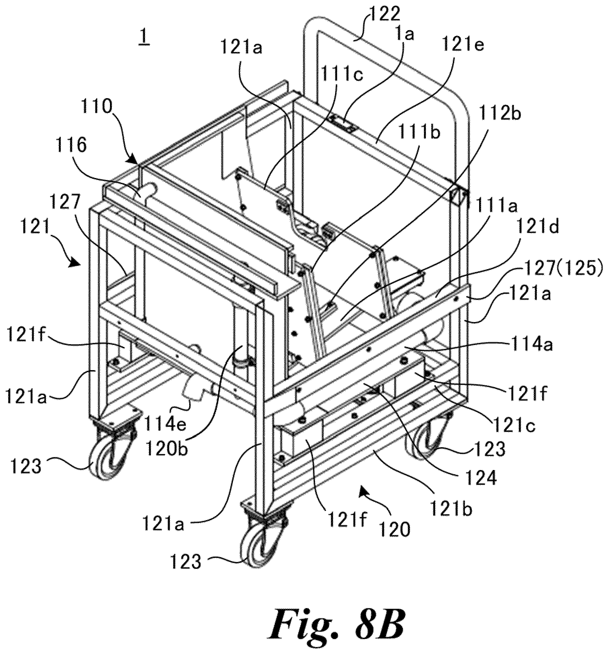

The substrate transportation cart 1 transports the substrate W housed in the cassette 4 while immersed in liquid. As illustrated in Figs. 7 and 8, the substrate transportation cart 1 includes a tank 110 and a transporter 120. The tank 110 is a container that can contain the substrate W housed in the cassette 4 in the direction allowing to be taken out from above while immersed in liquid. The tank 110 is a rectangular box with an opened top. For example, the liquid contained in the tank 110 to which the substrate W is immersed is pure water. In the description below, pure water is just referred to as water.

A part or all of the container forming the tank 110 is formed of transparent material. Transparent here means electromagnetic wave (infrared, laser light, etc.) for reading the identification information 42 of the cassette 4 contained in the tank 110 can be transmitted. Note that if the positions of the identification information 42 of the cassette 4 is fixed, at least portions corresponding to said positions should be transparent. Furthermore, if the positions of the identification information 42 is not fixed and the workers have to check the positions of the identification information 42, it is preferable that the tank 110 is transparent enough to visible light so that the identification information 42 is visible to the workers.

As illustrated in Figs. 6 and 8, the tank 110 includes a support 111, a guide 112, a direction definer 113, a draining mechanism 114, and a liquid level piping 116. The support 111 tilts and supports the cassette 4. The cassette 4 is supported in the tank 110 so that the opened side faces up to allow the substrate W to be taken out from above one by one.

As illustrated in Fig. 6, the support 111 includes a support bottom 11a, a support back 111b, and a support front 111c. The support bottom 111a is a plate that inclines upward at the front side and supports the bottom of the cassette 4. The support back 11b and the support front 111c are a pair of plates standing up perpendicular to the support bottom 111a so that the upper portion falls backward and supporting the cassette 4 from front and back. That is, the cassette 4 is supported by the support bottom 111a, the support front 111b, and the support back 111c so that the upper portion inclines backward. Note that, when the identification information 42 is marked at the predetermined positions of the cassette 4, the cassette 4 is contained in the tank 110 so that the identification information 42 faces the support front 111c. In this case, the identification information 42 can be read and visible by forming the part of the front surface of the tank 110, that is, the positions corresponding to the identification information by transparent material.

The guide 112 guides the cassette 4 inserted in the tank 110. As illustrated in Fig. 8A, the guide 112 includes a guide surface 112a and a rib 112b. The guide surface 112a is a pair of plates perpendicular to the support back 111b toward the support front 111c. The guide surface 112a guides the right and left of the cassette 4 when the tank 110 is inserted and restrict the tank 110 supported by the support 111 from moving in the right and left direction. The rib 112b is a pair of prismatic member fixed to the support bottom extending in the front and back direction, and is fitted to a groove of the cassette 4 and restrict the cassette 4 from moving in the right and left direction.

The direction definer 113 is a pair of prismatic member provided in the support back 111b and includes a groove 113a to which a protrusion (unillustrated) provided at the back side of the back surface of the cassette 4 is inserted. The direction definer 113 prevents the cassette 4 from being inserted incorrectly in the opposite front and back direction.

As illustrated in Figs. 7 and 8, the drainage mechanism is a mechanism that drains water in the tank 110. For example, water must be drained when water in which the substrate W is immersed is excessively contaminated by slurry by draining the contaminated water and supplying clean water to immerse the substrate W in the clean water and prevent the slurry from sticking to the substrate W again. The draining mechanism 114 includes a piping 114a, a first valve 114b, the driving coupler 114c, and a second valve 114d. The piping 114a is connected to a drainage outlet 110a provided at the lower portion of the front of the tank 110 and is branched to right and left. The left branch of the piping 114a when viewed from the front side (refer Figs. 7A and 8A) extends along the side and back of the tank 110 via the first valve 114b, and the end thereof is the drainage outlet 114e facing downward.

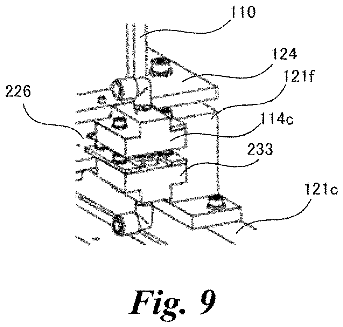

The first valve 114b is a valve that opens and closes by the control from outside. The first valve 114b of the present embodiment is a pneumatic open/close valve. The driving 114c is one of the fittings that connects the first valve 114b and pneumatic circuit for driving, and is connected to the first valve 114b by an unillustrated piping. The driving coupler 114c is connected to a driving coupler 233 described later (refer Fig. 9). The second valve 114d is a manual valve that opens and closes by the worker operating the handle. The second valve 114d is provided at the end of the right branch of the piping 114a when viewed from the front side (refer Figs. 7A and 8A).

As illustrated in Figs. 5 and 7B, the liquid level piping 116 is a piping extending in the vertical direction of the tank 110 and is connected to the back of the tank 110 so that both ends communicate with the interior of the tank 110. Water in the tank 110 flows into the liquid level piping 116 and the height of the liquid level of the liquid level piping 116 is maintained the same as the liquid level of the tank 110. The liquid level piping 116 is formed by material that can transmit the detection light of a liquid level sensor 217 described later.

As illustrated in Figs. 7, 8, and 10, the transporter 120 is a mechanism in which the tank 110 is loaded for the worker to move the tank 110. The transporter 120 includes a frame 121, a handle 122, a caster 123, a loader 124, and a positioning member 125. The frame 121 is a structure that configures the outer appearance of the substrate transportation cart 1. The frame 121 includes a vertical frame 121a and horizontal frames 121b to 121e surrounding the tank 110 in a box-shape. The vertical frame 121a is a metal column arranged in the vertical direction at the apex of the rectangle.

The horizontal frames 121b to 121e are horizontal metal beams fixed to horizontally pass over between each vertical frame 121. The lowest horizontal frame 121b and the second lowest horizontal frame 12c are arranged in a U-shape so that the back side is open. That is, the horizontal frames 121b and 121c are provided so as to pass over between each vertical frame 121a except for the back side. When the substrate transportation cart 1 is carried in the substrate delivery apparatus 2, a separation mechanism 224 described later enters below the tank 110 from the opened back side without the horizontal frames 121b and 121c. The third lowest horizontal frame 121d and the uppermost horizontal frame 121e are arrange in a rectangle shape to surround four sides of the tank 110. The front side of the horizontal frame 121e is marked with identification information 1a to identify each substrate transportation cart 1. For example, the identification information 1a is a bar code and 2D code.

Note that a liquid receiver 120a is provided around the tank 110 in the horizontal frame 121e. The liquid receiver 120a is a flat plate provided to surround the upper portion of the tank 110. The liquid receiver 120a receives the liquid spilled out from a liquid supply 240. An unillustrated drainage port is provided in the liquid receiver 120a. The drainage port is connected to the piping 114a via a drainage piping 120b (refer Fig. 7B).

The handle 122 is a member for the worker to hold, push and pull to drive the substrate transportation cart 1. The handle 122 is a U-shape pipe fixed to connect the upper ends of the two vertical frames 121a at the front side. The caster 123 is a driving member provided in the lower ends of the four vertical frames 121a and includes wheels and bearings. Note that the caster 123 at the front side may be swivel-type to easily change the direction. Furthermore, it is preferable to use the caster 123 with a damper to absorb vibration at the time of transportation.

As illustrated in Figs. 7 and 8, the loader 124 is a member in which the tank 110 is loaded. The loader 124 is a rectangular seat plate fixed at the bottom of the tank 110. The loader 124 is supported separately from the transporter 120. That is, four rectangular support blocks 121f are provided in the right and left horizontal frames 121c, and the bottom surface of the loader 124 is placed on the top surface of the support block 121f.

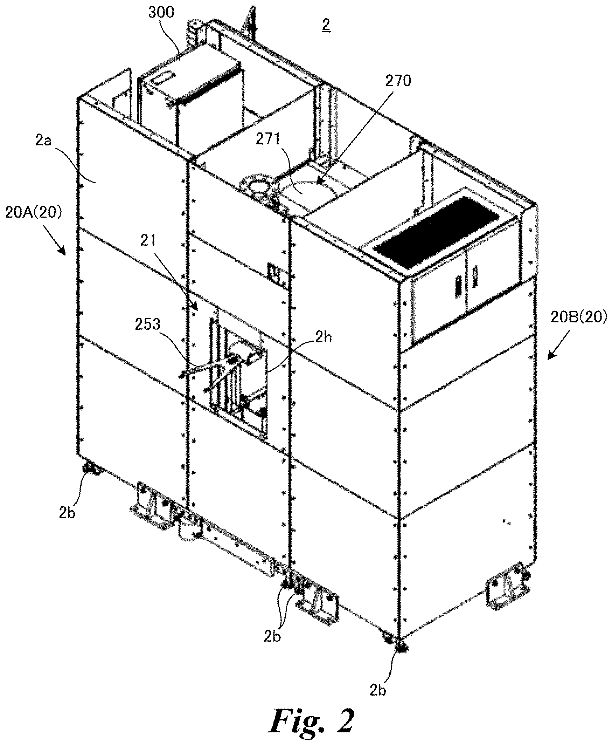

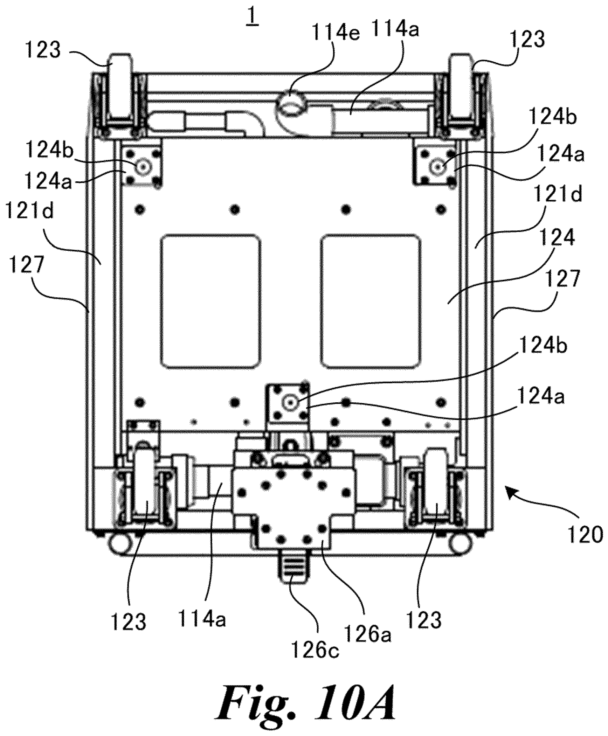

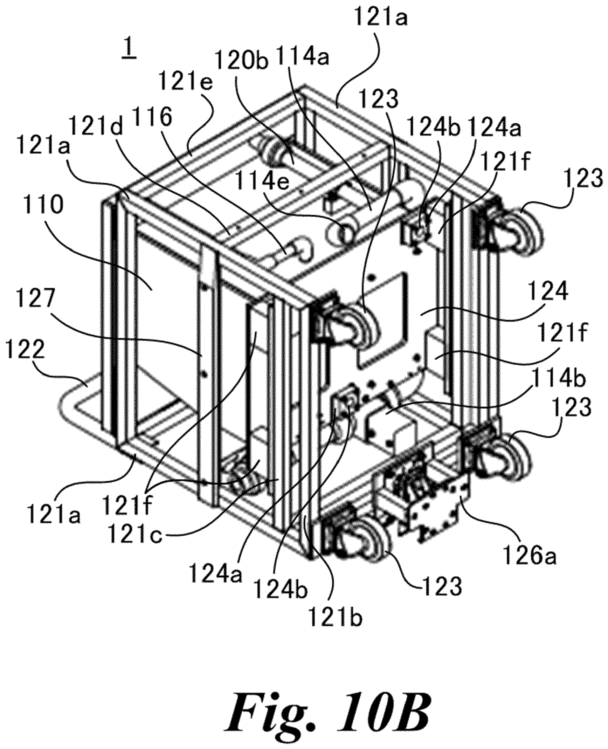

Although unillustrated, a vertical pin is provided in the loader 124, and the pin s inserted in a hole provided in the top surface of the support block 121f to prevent the displacement of the loader 124 in the horizontal direction. However, the loader is rises away from the support block 121f when force is applied from below. That is, the loader 124 ascends and descends by the separation mechanism 224 described later. Furthermore, as illustrated in Fig. 10, three rectangular receiving blocks 124a are provided in the bottom surface of the loader 124 at the center of the front side and both ends of back side. A hole 124b into which a pin 226a (refer Fig. 2) of a base 226 described later is formed in the receiving block 124a.

As illustrated in Figs. 5, 7, and 8, the positioning member 125 includes a front mounting portion 126 and a side abutting portion 127. The front mounting portion 126 is provided at the center of the lowest horizontal frame 121b at the front side. The front mounting portion 126 includes an engaging plate 126a, a cylinder 126b, and a pedal 126c. The engaging plate 126a is a horizontal plate with a convex shape. The cylinder 126b is fixed to the horizontal frame 121b and supports the engaging plate 126a in a elevatable manner.

The pedal 126c is a member for the worker to press down the engaging plate 126a by their foot. The engaging plate 126a descends when the pedal 126c is pressed down so as to be movable between an engaging position where the engaging plate 126a engages with an engaging member 222 described later and a release position where the engaging plate 126a is released from the engaging member 222 by pushing up the pedal 126c. The side abutting portion 127 is provided along the right and left outer surface of the third lowest horizontal frame 121d and is a plate in contact with a guide roller 223 described later. An inclined portion that is thin at the tip and thickens toward the back side is provided at the front side of the side abutting portion 127.

### [Substrate Delivery Apparatus]

As illustrated in Figs. 3 and 4, the substrate delivery apparatus 2 is an apparatus that houses the substrate transportation cart 1, takes out the substrate W immersed in water in the tank 110 from the cassette 4 by a take-out device 250, and carries the substrate W to the washing apparatus 3. The substrate delivery apparatus 2 includes a rectangular casing 2a. The casing 2a is installed so that the back side thereof is adjacent to the washing apparatus 3. The substrate delivery apparatus 2 includes docking modules 20A and 20B and a robot module 21 formed by dividing the casing 2a in three. Note that the bottom of the casing 2a is arranged to have a gap between the installation surface by legs 2b such as adjusters to ensure ventilation to the outside.

### [Docking Module]

As illustrated in Fig. 1, the docking modules 20A and 20B are vertical rectangular regions configured on the right and left of the casing 2a. Doors 2c are provided at the front of the docking modules 20A and 20B so that the entire front side can be opened and closed.

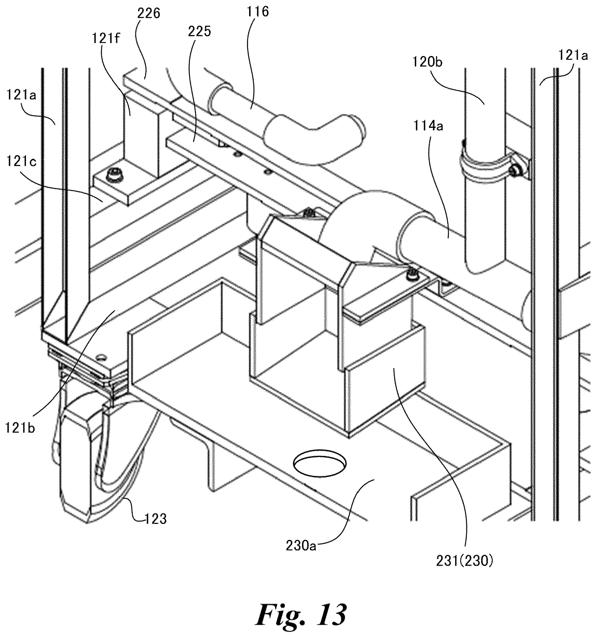

Since the right and left docking modules 20A and 20B have the same configuration inverted in the right and left except for a housing space 22 above, hereinafter, they are described as the docking module 20 unless they are distinguished. Furthermore, Figs. 1 and 3 illustrate the example in which the substrate transportation cart 1 is housed in the docking module 20A, and Figs. 4, 11, 14, and 15 illustrate the interior of the docking module 20B, the substrate transportation cart housed therein, and the take-out device 250 that takes out the substrate W from the tank 110, and they are substantially the same. The docking module 20 includes a cart housing 210, a positioning mechanism 220, a drainage 230, and the liquid supply 240 (refer Figs. 5, 11, 12, 13, and 14).

### (Cart Housing)

As illustrated in Figs. 1, 3, 11, and 14, the cart housing 210 is a region with a housing room 211 to accept and house the substrate transportation cart 1 from the outside. The housing room 210 includes a vertical frame 212 and horizontal frames 213 to 216 configured inside the casing 2a. The vertical frame 212 is a metal column arranged in the vertical direction at four corners of the docking module 20. The horizontal frames 213 to 216 are horizontal metal beams fixed to horizontally pass over between each vertical frame 212. The lowest horizontal frame 213 is arranged in a U-shape along the bottom of the casing 2a so that the front side is open. That is, the horizontal frame 213 is arranged pass over each vertical frame 212 except for the front side where the substrate transportation cart 1 enters.

The second lowest horizontal frame 214 is arranged in a U-shape along the height corresponding to the side abutting portion 127 of the substrate transportation cart 1 so that the front side is open. That is, the horizontal frame 214 is arranged pass over each vertical frame 212 except for the front side where the substrate transportation cart 1 enters. The third lowest horizontal frame 215 is arranged in a U-shape along the height of the upper periphery of the tank 110 of the substrate transportation cart 1 so that the front side is open. That is, the horizontal frame 215 is arranged pass over each vertical frame 212 except for the front side where the substrate transportation cart 1 enters. The uppermost horizontal frame 216 is arranged in a rectangular shape so as to surround four sides of front, back, right, and left. Thus, the region surrounded by the vertical frame 212 and the horizontal frames 213 to 216 forms the housing room 211 into which the substrate transportation cart 1 enters from the front side.

### (Positioning Mechanism)

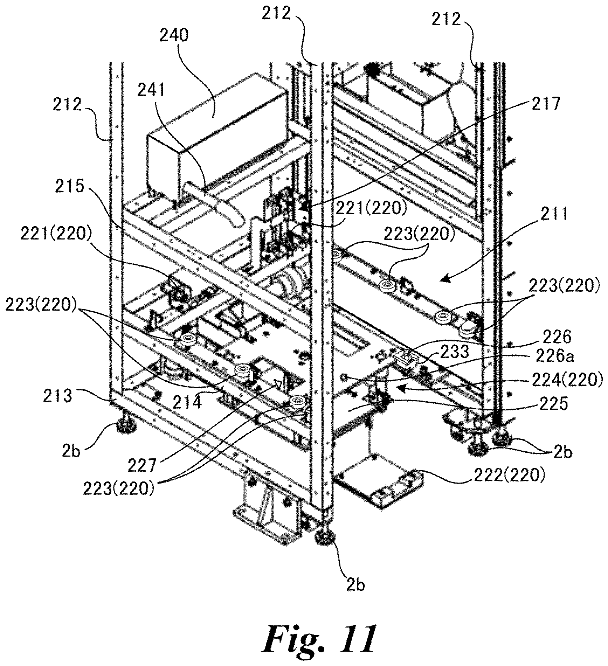

The positioning mechanism 220 is a mechanism that positions the substrate transportation cart 1 at a certain position. As illustrated in Figs. 5 and 11, the positioning mechanism 220 includes a buffer member 221, the engaging member 222, the guide roller 223, and the separation mechanism 224. The buffer member 221 is a member that mitigates the impact when the substrate transportation cart 1 is carried in and applies forward force to the substrate transportation cart 1. For example, the buffer member 221 is a pair of shock absorbers fixed to the beam 214a passed over in the right and left at the front of the horizontal frame 214 at the back side so that a tip of the rod faces the front side.

The engaging member 222 is a member to which the engaging plate 216a of the substrate transportation cart 1 fits. The engaging member 222 is a prismatic block extending in the horizontal right and left direction, and the front end of the engaging plate 126a abuts thereto. As illustrated in Fig. 11, the engaging member 222 extends down in the vertical direction from the center of the front end of a support plate 225 described later and is further fixed on the plate that is bent horizontally.

The buffer member 221 applies forward force to the back side of the horizontal frame 121d of the substrate transportation cart 1, and the engaging plate 126a at the front side abuts the engaging member 222 so that the substrate transportation cart 1 restricted from moving forward. Therefore, the buffer member 221 and the engaging member 222 act as the positioning member in the forward and back direction.

A plurality of the guide rollers 223 is provided in the right and left horizontal frame 214 extending in the forward and back direction so as to protrude inward with the vertical direction being the axis. The guide roller 223 contacts with the side abutting portion 127 of the substrate transportation cart 1 that had been carried in and rotates to guide the movement of the substrate transportation cart 1. The distance between the guide rollers provided in the right and left horizontal frame 214 is fixed and is same as the width of the substrate transportation cart 1.

However, among the plurality of the guide rollers 223 provided in the right and left horizontal frame 214, the foremost pair of the guide rollers 223 is elastically supported by a damper (unillustrated), and the distance therebetween is broader than the guide rollers 223 at other positions. Therefore, even if the substrate transportation cart 1 that has been carried in is slanted or misaligned in the right and left direction, the substrate transportation cart 1 abuts with one of the pair of the foremost guide roller 223, so that the impact is absorbed and the substrate transportation cart 1 is guided between the fixed guide roller 223 at the back side and is positioned at fixed position. Therefore, the guide roller 223 acts as the positioning member in the right and left direction. As described above, the substrate transportation cart 1 is positioned in the horizontal direction by the positioning member in the forward and back direction and the positioning member ins the right and left direction.

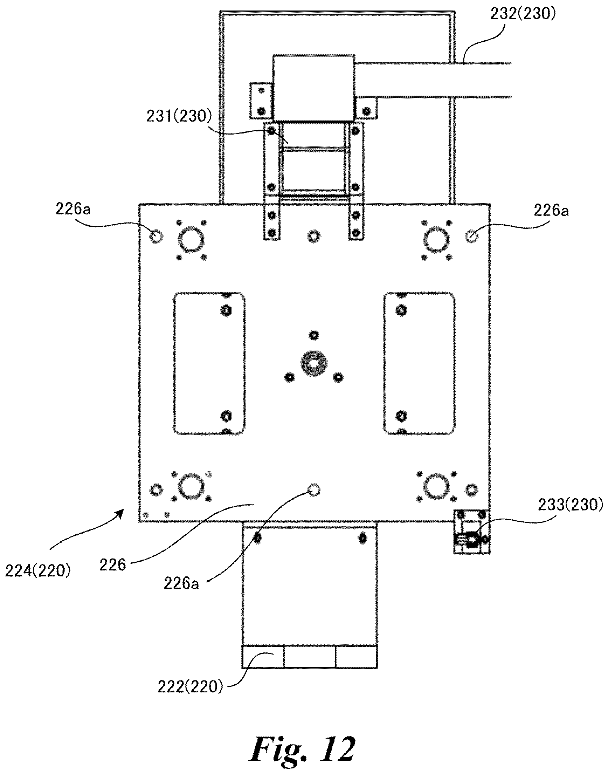

The separation mechanism 224 is a mechanism that separates the loader 124 from the transporter 120 together with the tank 110. As illustrated in Figs. 11 and 12, the separation mechanism 224 includes the support plate 225, a base 226, and a cylinder 227. The support plate 225 is a rectangular plate and the back end thereof is supported by a beam extending from the horizontal frame 213. The base 226 is a rectangular plate and is elevatably supported by elevation shaft (unillustrated) provided at four corners between the base 226 and the support plate 225. Three pins 226a are standing on the upper surface of the base 226. The pin 226a corresponds to a hole 124b provided in the receiving block 124a of the loader 124. As described above, when substrate transportation cart 1 is positioned in the horizontal direction, the hole 124b of the receiving block 124a comes right above the pin 226a (refer Fig. 10).

The cylinder 227 is provided between the support plate 225 and the base 226 and is a drive source to ascend or descend the base 226. The base 226 ascended by the cylinder 227 ascends the loader 124 positioned in the horizontal direction by the pin 226a entering and pressing up the hole 124b of the receiving block 124a and stops at the predetermined height position. This height is a position where the take-out device 250 described later can take out the substrate W from above the tank 110 loaded on the loader 124.

By this, even when the loader 124 is separated from the transporter 120, since the pin provided in the loader is inserted in the hole of the support block 121f, the loader 124 can be ascended while being positioned in the horizontal direction without being displaced. That is, the separation here means that the loader 124 is not completely separated from the transporter 120 and moves within the frame 121 at a level the loader 124 is separated and ascended from the support block 121f.

### (Drainage)

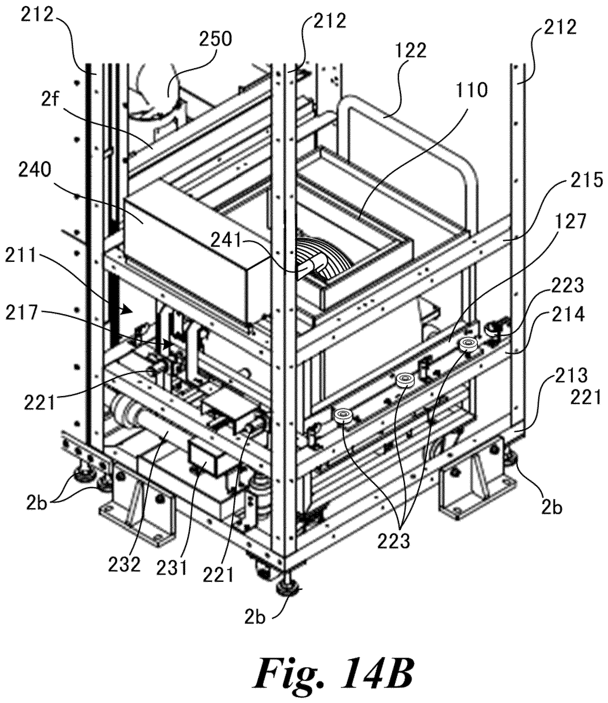

As illustrated in Figs. 12, 13, and 14B, the drainage 230 is a configuration to drain water out from the tank 110. The drainage 230 includes a drainage duct 231, a drainage piping 232, and the driving coupler 233. The drainage duct 231 a box-shaped container with an opened top provided at the back side of the housing room 211. The opening of the drainage duct 231 faces the drainage outlet 114e of the piping 114a that runs around to the back side of the tank 110. The drainage piping 232 has one end connected to the drainage duct 231 and the other end extending to the lower portion of the robot module 21 and connected to the drainage receiver 280 described later. Note that, as illustrated in Fig. 14B, the drainage 230 is supported by the horizontal frame 213 at the back side via the liquid receiver 230a.

The driving coupler 233 is the other of the fitting that connects to the driving coupler 114c of the substrate transportation cart 1. The driving coupler 233 is connected to an unillustrated pneumatic circuit that supplies air for driving. The driving coupler 233 is fixed to the base 226 at a position facing the driving coupler 114c of the positioned substrate transportation cart 1 (refer Fig. 9). Therefore, when the base 226 ascends by the cylinder 227, the driving coupler 233 is connected to the driving coupler 114c, so that the first valve 114b can be opened and closed by air supplied from the pneumatic circuit.

### (Liquid Supply)

The liquid supply 240 is a configuration that supplies water to the tank 110 (refer Fig. 11). The liquid supply 240 is installed in the horizontal frame 215 at the back side, and the beam 215a passing over the right and left horizontal frame 215. The liquid supply 240 includes a liquid supply piping 241 and an unillustrated liquid supply valve. In the liquid supply piping 241, one end is connected to a liquid supply device such as a pump and a tank, and the other end extends to the upper portion of the housing room 211 and is bent downward toward the upper portion of the tank 110 of the substrate transportation cart 1 housed in the housing room 211. The liquid supply valve is connected to an unillustrated pneumatic circuit that supplies air for driving and controls the liquid supply by the liquid supply piping 241 by opening and closing. Note that, as illustrated in Figs. 5 and 11, the liquid level sensor 217 to detect the liquid level of water stored in the housed tank 110 in a non-contact manner is provided at the back side of the housing room 211. The liquid level sensor 217 is attached to the beam 214a and is arranged to sandwich the liquid level piping 116 of the tank 110 housed in the housing room 211. As described above, water in the tank 110 flows into the liquid level piping 116 and the height of the liquid level of the liquid level piping 116 is maintained the same as the liquid level of the tank 110. Therefore, the detection light from the liquid level sensor 217 transmits the liquid level piping 116 and detects the liquid level in the liquid level piping 116, to detect the liquid level in the tank.

### [Robot Module]

As illustrated in Figs. 2, 3, and 4, the robot module 21 is a vertical rectangular region configured between the docking modules 20A and 20B of the casing 2a. Lid 2d is provided at the front of the robot module 21 so that the entire front side is closed. A region where the substrate W taken out by the take-out device 250 is carried in and out is formed in the robot module 21.

Partition walls 2e is provided between the robot module 21 and the docking modules 20A and 20B. Windows 2f with a size that enables the take-out device 250 to take out the substrate W is provided to each partition wall 2e. This window 2f can be opened and closed by a shutter 2g. A window 2h with a size that enables the take-out device 250 to carry out the substrate W to the washing apparatus 3 is provided to the back side of the robot module 21. This window 2h can be opened and closed by a shatter provided at the washing-apparatus side. The robot module 21 includes the take-out device 250, a washer 260, and an air blower 270.

### (Take-Out Device)

As illustrated in Figs. 3, 4, and 15, the take-out device 250 is a device that takes out the substrate W from the tank 110 loaded in the substrate transportation cart 1 housed in the housing room 211 and delivers the substrate W to the adjacent washing apparatus 3. The take-out device 250 of the present embodiment is an articulated robot, and includes a plurality of shafts 251 that serves as joints, a plurality of link arms connected by the shafts 251, and a holder 253 provided at a tip of the terminal link arm 252.

By controlling an unillustrated motor to drive the shaft 251, the holder 253 is inserted in the tank 110 at an inclination angle along the substrate W, holds one substrate W, pull out the substrate W from the cassette 4 in the tank 110, and deliver the substrate W to the washing apparatus 3 at the back side at a horizontal angle. That is, the take-out device 250 of the present embodiment is a robot that transport the substrate W from the tank 110 to the washing apparatus 3 one by one.

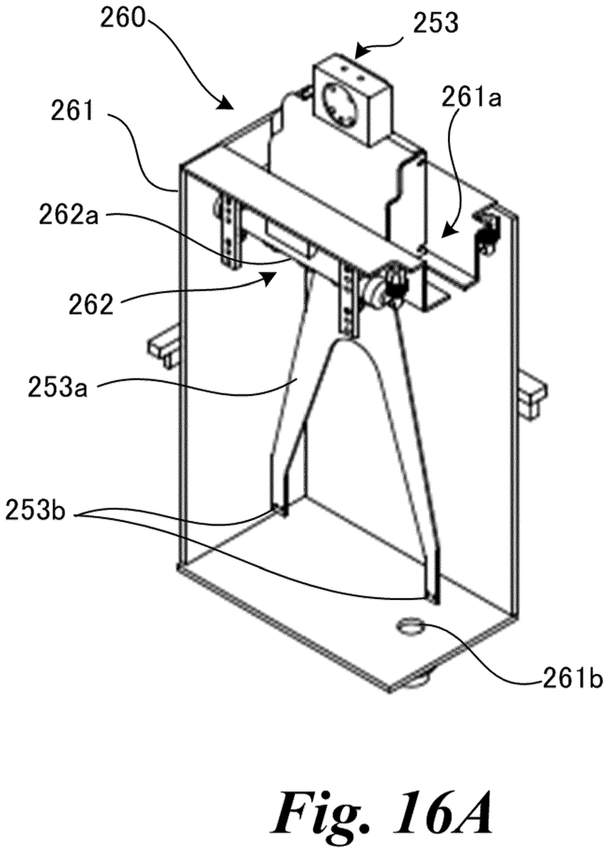

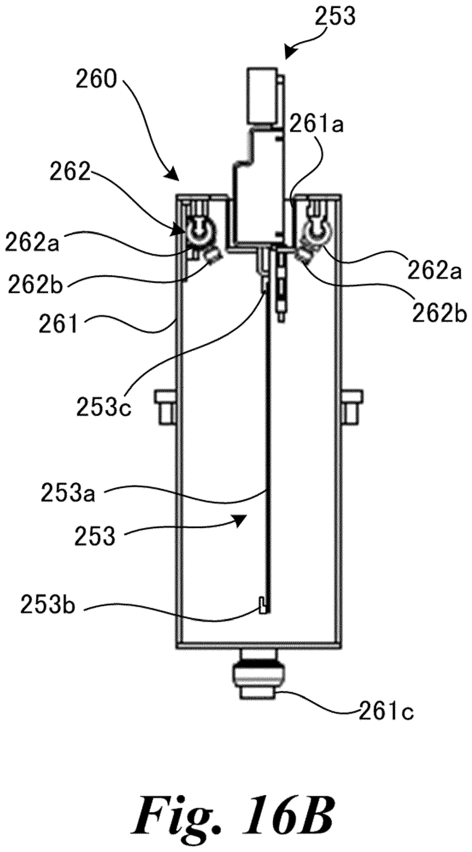

As illustrated in Figs. 2 and 3, the holder 253 is a robot hand that holds the substrate W. As illustrated in Fig. 16A and 16B, the holder 253 includes a plate 253a, a movable claw 253b, and a fixed claw 253c. The plate 253a is a V-shaped plate with a bifurcated tip. The movable claw 253b is provide in the bifurcated tip of the plate 253a, and the fixed claw 253c is provided at a root of the plate 253a. The movable claw 253b is provided with variable distance from the fixed claw 253b by an unillustrated driving mechanism. Therefore, the movable claw 253b is provided to be movable between a holding position where the movable claw 253b contact with the edge of the substrate W and hold the substrate W with the fixed claw 253c and a release position where the claws release the edge of the substrate W away.

Note that, as illustrated in Figs. 3 and 4, the take-out device 250 is provided on the support base 2j provided in the horizontal direction so that the space below is free inside the robot module 21. An unillustrated driving unit to drive the take-out device 250 is arranged in the space below the support base 2j, and furthermore, a drainage receiver 280 is provided below the driving unit. The drainage receiver 280 is connected to the drainage piping 232 of the rug drainage 230 and is a container that can temporarily store water from the tank 110. Liquid drained from the drainage receiver 280 is drained outside via an unillustrated drainage port and drainage path.

### (Washer)

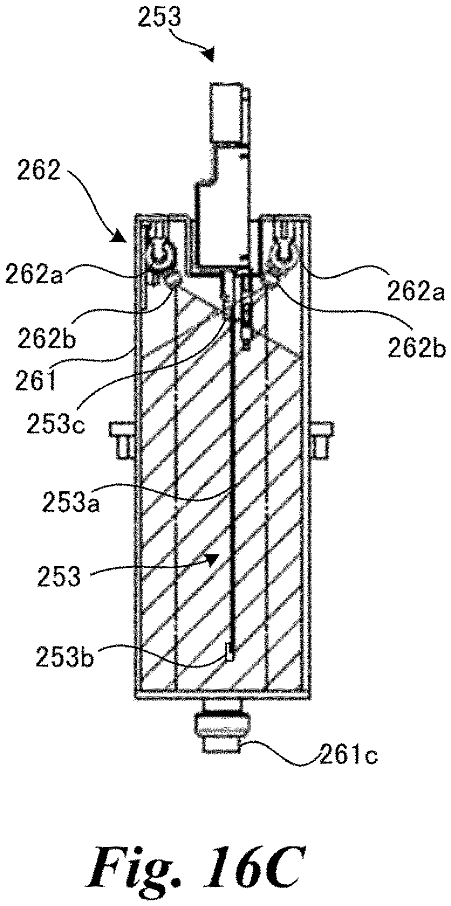

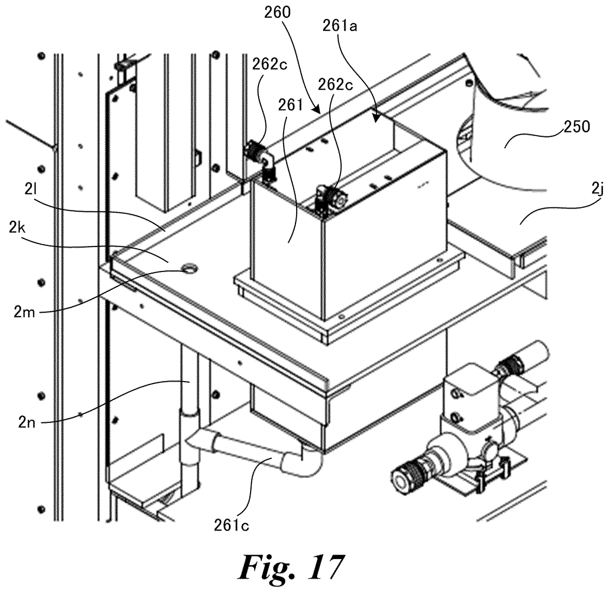

As illustrated in Figs. 16A, 16B, 16C, and 17, the washer 260 is a device that washes the holder 253. The washer 260 includes a washing container 261 and a liquid supply 262. The washing container 261 is a box with an opening 251a on the top to which the holder 352 can be inserted. As illustrated in Figs. 3 and 17, the washing container 261 is fixed to a base 2k integrally provided to the support base 2j at the back side of the support base 2j. Washing liquid from the holder 253 drops on the base 2k when the washed holder 253 moves out from the washing container 261. The base 2k is provided with an enclosure 21 which is the raised edge to receive the dropped washing liquid, and a drainage port 2m to drain the dropped washing liquid. The drainage port 2m is connected to one end of the drainage piping 2n. The other end of the drainage piping 2n is extended downward and is connected to the drainage receiver 280.

As illustrated in Fig. 16, the liquid supply 262 sprays the washing liquid such as water to the holder 253 inserted in the washing container 261 and washes the holder 253. The liquid supply 262 includes a piping 262a provided at the ceiling side in the washing container 261 for the washing liquid, and a nozzle 262b attached to the piping 262a. A pair of the piping 262a is provided at positions sandwiching the holder 253 in the washing container 261 in the horizontal direction parallel with the plate 253a of the holder 253. The piping 262a is connected to an unillustrated supplying device of the washing liquid via a port 262c in Fig. 17. A plurality of the nozzles 262b is provided along the piping 262a and is arranged in the direction to eject the washing liquid toward the front and back of the holder 253.

A drainage port 261b is provided on the bottom surface opposite the opening 261a of the washing container 261. The drainage port 261b is connected to a drainage piping 261c. The drainage piping 261c is connected to the drainage receiver 280 by merging and connecting to the drainage piping 2n from the base 2k.

### (Air Blower)

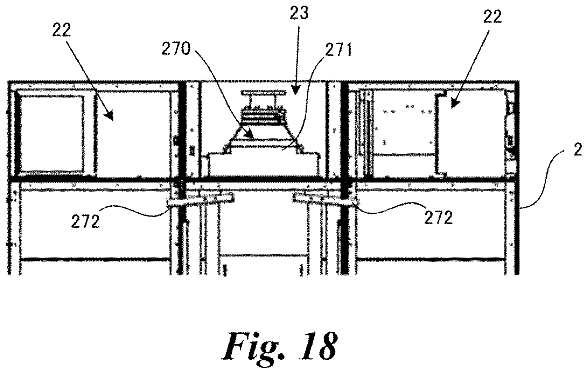

As illustrated in Figs. 4 and 18, the air blower 270 generates downflow from above the housing room 211 and the take-out device 250. The air blower 270 includes a blower 271 and a regulation plate 272. The blower 271 supplies purified air downward. The blower 271 is a fan filter unit (FFU) installed in the housing room 23 in the upper portion of the robot module 21 in the casing 2a. The fan filter unit has a UPLA filter that purifies air to be supplied.

The regulation plate 272 allows air supplied from the blower 271 to flow above the docking modules 20A and 20B and generates downflow also in the housing room 211. The regulation plate 272 is a pair of plates arranged with distance therebetween in the right and left below the blower 271. Since the regulation plate 272 is inclined to become lower from the robot module 21 side to the docking modules 20A and 20B, the regulation plate 272 allows the air from the blower 271 to flow to the housing room 211.

### [Controller]

The controller 300 is a computer that controls each section of the substrate delivery apparatus 2. The controller 300 includes a processor that executes programs, a memory that stores various information such as programs and operation condition, and a driving circuit that drives each component. As illustrated in Figs. 1 to 4, the controller 300 of the present embodiment is loaded in the housing space 22 in the upper portion of the casing 2a.

Note that, the controller 300 is connected to an input device to input information and a display device to display information. In the present embodiment, a display 310 with a touch panel is provided on the lid 2d of the robot module 21 as the input device and the display device. Furthermore, the input device includes a reading device such as a bar code reader to read the identification information 42 of the cassette 4 and the identification information 1a of the substrate transportation cart 1.

### [Action]

The operation of the present embodiment above will be described. Note that the substrate transporting method to transport the substrate W and the substrate delivery method to deliver the substrate W to the washing apparatus 3 by the below procedures are also aspects of the present embodiment.

### (Mounting the Cassette)

In the polishing apparatus, after the substrate W was polished with the abrasive applied, the substrate W is rinsed by water, is housed in the cassette, and is carried out. At this time, the substrate W is wet with water with abrasive thereon.

Meanwhile, the tank 110 of the substrate transportation cart 1 is filled with water up to the predetermined level in advance. As illustrated in Figs. 5 and 6, the worker immerses the cassette 4 housing the substrate W polished by abrasive in the tank 110. At this time, the cassette 4 is immersed so that the opening of the cassette 4 faces the opening of the tank 110. That is, the top of the cassette 4 becomes the opening where the substrate W can be taken out, and the cassette 4 is inserted in the tank 110 in the direction in which the back-side protrusion enters the groove 113a of the direction definer 113 (refer Fig. 8A). By immersing the cassette 4 in the tank in this way, since the top and bottom of the cassette 4 is opened, water enters into the cassette 4 and the substrate W is immersed in water.

The both sides of the cassette 4 is guided by the right and left guide surfaces 112a and the front and back surface of the cassette 4 are guided by the support back 111b and the support front 111c, so that the cassette 4 is descended, and is supported and set by the support bottom 111a which the bottom is inclined. At this time, the rib 112b of the support bottom 111a (refer Fig. 8A) enters the groove of the cassette 4.

By this, since the cassette 4 is supported diagonally in the tank 110, each substrate W in the tank 110 is stopped at a position where the substrate W is inclined to fall behind the partition 41. Therefore, the inclined direction of each substrate W housed in the cassette 4 becomes uniform, the distance between each other becomes uniform. Therefore, the position where the take-out device 250 takes out each substrate W becomes uniform, and the positioning of the holder 253 is facilitated. Note that, when the substrate W is inclined as described above, the substrate W is housed in the cassette 4 so that the processed surface is on the upper side.

### (Carrying in the Substrate Transportation Cart)

The worker holds the handle 122 of the substrate transportation cart 1 and runs the caster 123 to transport the substrate W loaded on the substrate transportation cart 1 in front of the docking module 20A of the substrate delivery apparatus 2. Then, the worker read the identification information 42 of the cassette 4 and the identification information 1a of the substrate transportation cart 1 by the reading device. For example, the worker operates the hand held barcode reader to read the identification information 42 and 1a. The identification information 42 and 1a is stored in the controller 300, and the cassette 4 housing the substrate W to be delivered and the substrate transportation cart 1 to which the cassette 4 is transported is managed. Note that the air blower 270 generates downflow by purified air from above the housing room 211 and the take-out device 250 in the casing 2a of the substrate delivery apparatus 2.

The worker opens the door 2c of the docking module 20A, and pushes and carries in the substrate transportation cart 1 to the housing room 211 of the cart housing 210 from between the pair of the foremost guide rollers 223. Then, since the right and left guide rollers 223 contact with the side abutting portion 127 of the substrate transportation cart 1 and rotate, as illustrated in Fig. 5, the substrate transportation cart 1moves to the back until it abuts the rod of the buffer member 221, while being guided from right and left. By this, the substrate transportation cart 1 is positioned in the right and left direction by the right and left guide rollers 223.

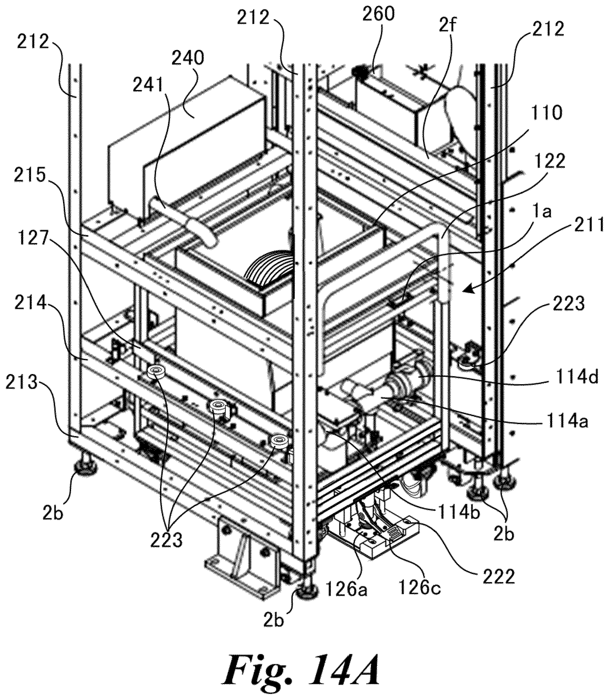

As illustrated in Fig. 14(A), the worker presses the pedal 126c by foot, so that the engaging plate 126a fits to the engaging member222 to be the engaging position. By this, when the worker releases hands from the substrate transportation cart 1 while the substrate transportation cart 1 is pushed against the buffer member 221 and the engaging plate 126a is lowered, the substrate transportation cart 1 is pushed back by the buffer member 221 and the engaging plate 126a fits to the engaging member222 and stops, so that the substrate transportation cart 1 is positioned in the front and back direction.

As described above, after the substrate transportation cart 1 is positioned in the front, back, right, and left direction, that is, the horizontal direction, the worker operates the touch panel of the display 310 to operate the cylinder 227 to ascend the base 226. Then, the pin 226a of the base 226 enters the hole 124b of the receiving block 124a and pushes up the loader 124. As illustrated in Figs. 14A and 14B, the loader 124 ascends and stops at certain position where the substrate W can be taken out from the upper portion of the tank 110 by the take-out device 250. By this, the tank 110 is positioned in the height direction. At this time, the loader 124 is separated from the transporter 120, but since the pin provided of the loader 124 is inserted in the hole of the support block 121f, the positioning in the horizontal direction without displacement is achieved.

Note that when the base 226 ascends, the driving coupler 233 fixed to the base 226 also ascends so that the driving coupler 233 is connected to the facing driving coupler 114c. By this, the first valve 114b to drain liquid from the tank 110 can be opened and closed by the pneumatic circuit, and the draining and supplying of the liquid is described later.

### (Taking Out the Substrate)

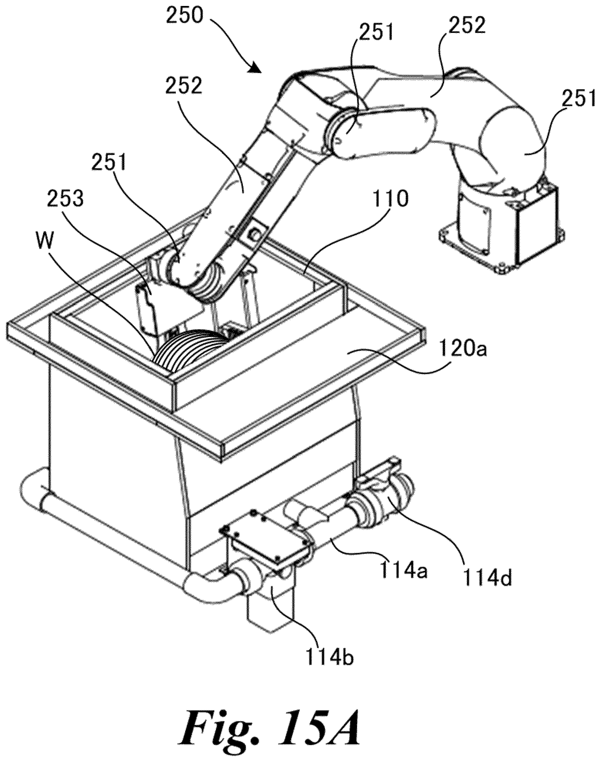

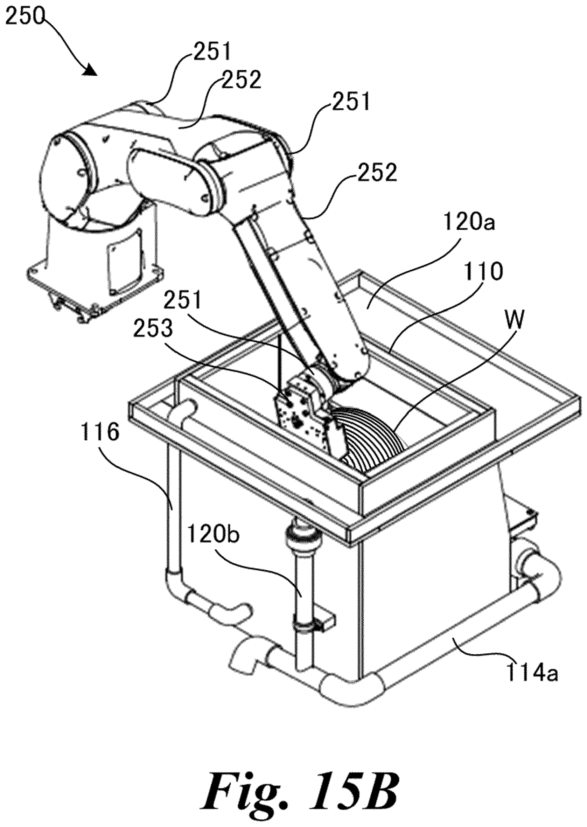

As described above, when the tank 110 is positioned in the height direction, the shutter 2g is opened and the holder 253 enters the housing room 211 from the window 2f by the action of the take-out device 250 and the link arm 252, as illustrated in Fig. 4. As illustrated in Fig. 15, the holder 253 is inserted into the tank 110 along the inclination of any one of the substrate W from above the tank 110. At this time, the holder 253 is inserted from the below inclined substrate W, that is, the side opposite the processed surface. Since the fixed claw 253c of the holder 253 engages the upper edge of the substrate W, and the movable claw 253b engages the lower edge of the substrate W by moving to the holding position, the substrate W is held between the fixed claw 253c and the movable claw 253b.

Then, the substrate W and the holder 253 are pulled out by the action of the link arm 252 of the take-out device 250. Note that any substrate W may be taken out and is not limited, however, it is considered that the substrate W is taken out one by one from the support-back-111b side of the cassette 4. The substrate W held by the holder 253 and taken out from the tank 110 once enters the robot module 21 by the action of the link arm 252.

Next, as illustrate in Figs. 2 and 3, the shutter provided in the washing apparatus 3 opens, and the substrate W held by the holder is carried out from the window 2h to the washing apparatus 3 by the action of the link arm 252. The substrate W held by the holder 253 is passed over to the washing apparatus 3 in the horizontal direction. Therefore, the substrate W is taken out from the tank 11, is immediately brought into horizontal state, and is passed over to the washing apparatus, thereby transported in the wet condition.

### (Washing the Substrate)

In the washing apparatus 3, the substrate W held by the holder 253 of the take-out device 250 is loaded on an unillustrated placement base. The robot hand of the washing apparatus transports the substrate W loaded on the placement base to the chamber in the washing apparatus 3, and the washing process is performed. The above process is repeated until all the substrate W in the tank 110 is delivered to the washing apparatus 3.

Then, the base 226 is descended by operating the cylinder 227. Accordingly, the loader 124 descends and is supported by the support block 121f of the transporter 120. The base 226 further descends, and the pin 226a gets out from the hole 124b of the receiving block 124a. Note that, at this time, the driving coupler 233 fixed to the base 226 gets out from the driving coupler 114c (refer Fig. 9) .

Then, the worker pushes up the pedal 126c to position the engaging plate 126a at the release position to release the engaging member222, allowing the substrate transportation cart 1 to move. The worker holds the handle 122, pulls out the substrate transportation cart 1 from the housing room 211, and moves and transports the substrate transportation cart 1 outside the docking module 20 to the polishing apparatus. Furthermore, the worker transports the empty cassette 4 to the polishing apparatus again and sets the cassette 4 in the polishing apparatus. Then, the substrate W polished in the polishing apparatus is housed in the cassette 4. The cassette 4 in which the substrate W is housed is housed in the tank 110, is transported to the substrate delivery apparatus 2, and is delivered to the washing apparatus 3, as described above.

Note that, in one of the two docking module 20, the operation of carrying the substrate transportation cart 1 and the delivering the substrate W may be performed as described above, while the other substrate transportation cart 1 transports the substrate W from the polishing apparatus. Then, after delivery operation of the substrate W in one of the docking modules 20 is completed, the substrate transportation cart 1 loading the substrate W may be transported to the housing room 211 of the other docking module 20 and the substrate W may be delivered. By this, the delivery of the substrate W can be performed continuously, and the processing efficiency can be improved.

### (Water Supply and Water Drain)

As described above, since water in the tank 110 of the substrate transportation cart 1 is contaminated due to the continuous use, re-attachment of the slurry to the substrate W can be prevented by once draining the contaminated water using drainage mechanism 114 and the drainage 230 and again supplying the purified water by the liquid supply 240, periodically or based on the inspection result of the contamination.

The operation of such water draining and water supplying will be described. Note that the water draining and water supplying are performed by the worker inputting and operating the touch panel from the display 310 when the cassette 4 is in the tank 110 and the substrate W is not in the cassette 4. Firstly, as described above, the substrate transportation cart 1 is housed in the housing room 211, the base 226 is ascended, and the driving coupler 233 is connected to the driving coupler 114c (refer Fig. 9). Here, if water in the tank 110 is to be replaced, the first valve 114b is opened by the pneumatic circuit. Then, water in the tank 110 flows out from the drainage outlet 110a to the piping 114a.

Water flows through the piping 114a extending in the side and back of the tank 110 and falls to the drainage duct 213 from the drainage outlet 114e at the end. Water fallen to the drainage duct 231 is temporarily stored in the drainage receiver 280 via the drainage piping 232. When the draining from the tank 110 is completed, the first valve 114b is closed.

Next, the liquid supply valve of the liquid supply 240 is opened, and water is supplied from above the tank 110 via the liquid supply piping 241. When the liquid level sensor 217 detects that the liquid level of water in the tank 110 becomes that predetermined height in which the substrate W in the cassette 4 can be immersed, the liquid supply valve is closed and the liquid supplying is stopped.

### (Washing the Holder)

Furthermore, when the delivering of the substrate W by the take-out device 250 is repeated, the washer 260 washes the holder 253. For example, the holder 253 may be washed when the number of times the substrate W is taken out (the number of the substrate W or the cassette units) is counted and said number of times reaches the predetermined number of times, or when the operation to transport the substrate W to the washing apparatus 3 is not performed (during standby), or when the worker inputs and operates the touch panel of the display 310 upon the worker's decision. As illustrated in Figs. 16A and 16B, when performing the washing, the take-out device 250 inserts the holder 253 from the opening 261a on the top of the washing container 261. As illustrated in Fig. 16C, the liquid supply 262 ejects washing liquid supplied from the pair of the piping 262a from the nozzle 262b toward the front and back of the holder 253.

### [Effect]

(1) The substrate delivery apparatus 2 of the present embodiment includes: a cart housing 210 having a housing room 211 that receives from outside and houses the substrate transportation cart 1 in which a tank 110 containing a plurality of substrates W and water is loaded; and a take-out device 250 that takes the substrate W out from the tank 110 loaded in the substrate transportation cart 1 housed in the housing room 211 and delivers the substrate W to the washing apparatus 3 that is the adjacent processing device.
   Therefore, the substrate W that had been housed in the tank 110 with water and transported from the polishing apparatus can be taken out from the tank 110 and delivered to the washing apparatus 3. Therefore, the substrate W can be transported between the polishing apparatus and the washing apparatus 3 installed apart from each other, while maintaining the wet surface of the substrate W. By this, the slurry is suppressed from sticking to the substrate W by preventing the drying if the substrate W even when the slurry used in the polishing attaches to the substrate W, and the slurry of the surface of the substrate W can be removed by the washing apparatus 3.
(2) the take-out device 250 takes out the substrate W from the tank 110, in which the cassette 4 in an inclined state and housing the plurality of the substrate W is housed and delivers the substrate W to the washing apparatus 3. Therefore, since the inclined direction of each substrate W housed in the cassette 4 becomes uniform, the positions of each substrate W when taken out by the take-out device 250 can be constant.
(3) the cart housing 210 includes the positioning mechanism 220 that positions the substrate transportation cart 1 at a predetermined position. Therefore, the positions of the tank 110 and the substrate W housed therein becomes the predetermined position, and the positioning by the take-out device 250 for taking out the substrate W can be easily and accurately performed, stabilizing the take-out operation.
(4) the positioning mechanism 220 includes the separation mechanism 224 that separates the tank 110 from the substrate transportation cart at the position the substrate W can be taken out by the take-out device 250. Therefore, when the substrate transportation cart 1 is housed in the housing room 211, even if the distance between the substrate W housed in the tank 110 and the take-out device 250 is long, the distance between the substrate W housed in the tank 110 and the take-out device 250 can be made short by separating the tank 110 from the substrate transportation cart 1, and the substrate W can be taken out by the take-out device 250.
(5) The cart housing 210 includes the drainage 230 that drains water from the tank 110 and the liquid supply 240 that supplies liquid to the tank 110. Therefore, when the water in the tank 110 is contaminated, the water can be drained and purified water can be supplied, reducing the slurry attaching again to the substrate W.
(6) The take-out device 250 includes the holder 253 that holds the substrate W and the washer 260 that washes the holder 253. Therefore, the slurry attached to the holder 253 when repeatedly taking out the substrate W can be removed by the washer 260, reducing the slurry attaching again to the substrate W.
(7) the air blower 270 generating downflow from above the housing room 211 and the take-out device 250 is provided. Therefore, the atmosphere around the housing room 211 and the take-out device 250 can be maintained clean by the downflow.

### (Modified Examples)

The present embodiment may be implemented as the below modified examples.
(1) although in the above aspect, two cart housings 210 are provided for the take-out device 250, there should be at least one cart housing 210 and the take-out device 250 Furthermore, a plurality of the take-out devices 250 may be provided. For example, the embodiment may include one docking module 20 and one robot module 21, or multiple docking modules 20 and robot modules 21 may be arranged alternately.
(2) The processing device used in the substrate delivery apparatus of the above aspect is not limited to the polishing apparatus and the washing apparatus if the devices require to transport the wet substrate. Correspondingly, the liquid contained in the tank 110 is not limited to pure water.

### [Other Embodiment]

As above, although the modified examples of the embodiments and portions according to the present disclosure are described, these modified examples of the embodiments and portions are only presented as examples and are not intended to limit the scope of the claims. These new embodiments described above can be implemented in other various forms, and various omission, replacement, modification, and change may be performed without departing from an abstract of the invention. These embodiments and modification thereof are included in the scope and abstract of the invention, and are included in the invention described in the scope of the claims.

### REFERENCE SIGN

- 1:: substrate transportation cart
- 1a, 42:: identification information
- 2:: substrate delivery apparatus
- 2a:: casing
- 2b:: leg
- 2c:: door
- 2d:: lid
- 2e:: partition
- 2f, 2h:: window
- 2g:: shutter
- 2j:: support base
- 2k:: base
- 21:: enclosure
- 2m:: drainage port
- 2n:: drainage piping
- 3:: washing apparatus
- 4:: cassette
- 20, 20A, 20B:: docking module
- 21:: robot module
- 22, 23:: housing space
- 25:: take-out device
- 41:: partition
- 110:: tank
- 110a:: drainage port
- 111:: support
- 111a:: support bottom
- 111b:: support back
- 111c:: support front
- 112:: guide
- 112a:: guide surface
- 112b:: rib
- 113:: direction definer
- 113a:: groove
- 114:: drainage mechanism
- 114a:: piping
- 114b:: first valve
- 114c, 233:: driving coupler
- 114d:: second valve
- 114e:: drainage port
- 116:: liquid level piping
- 120:: transporter
- 120a:: liquid receiver
- 120b:: drainage piping
- 121:: frame
- 121a:: vertical frame
- 121b - 121e:: horizontal frame
- 121f:: support block
- 122:: handle
- 123:: caster
- 124:: loader
- 124a:: receiving block
- 124b:: hole
- 125:: positioning member
- 126:: front mounting portion
- 126a:: engaging plate
- 126b:: cylinder
- 126c:: pedal
- 127:: side abutting portion
- 210:: cart housing
- 211:: housing room
- 212:: vertical frame
- 213-216:: horizontal frame
- 214a, 215a:: beam
- 217:: liquid level sensor
- 220:: positioning mechanism
- 221:: buffer member
- 222:: engaging member
- 223:: guide roller
- 224:: separation mechanism
- 225:: support plate
- 226:: base
- 226a:: pin
- 227:: cylinder
- 230:: drainage
- 230a:: liquid receiver
- 231:: drainage duct
- 232:: drainage piping
- 240:: liquid supply
- 241:: liquid supply piping
- 250:: take-out device
- 251:: shaft
- 252:: link arm
- 253:: holder
- 253a:: plate
- 253b:: movable claw
- 253c:: fixed claw
- 260:: washer
- 261:: washing container
- 261a:: opening
- 261b:: drainage port
- 261c:: drainage piping
- 262:: liquid supply
- 262a:: piping
- 262b:: nozzle
- 262c:: port
- 270:: air blower
- 271:: blower
- 272:: regulation plate
- 280:: drainage receiver
- 300:: controller
- 310:: display

## Claims

1. A substrate delivery apparatus comprising:
a cart housing having a housing room that receives from outside and houses a substrate transportation cart in which a tank containing a plurality of substrates and liquid is loaded; and
a take-out device that takes the substrate out from the tank loaded in the substrate transportation cart housed in the housing room and delivers the substrate to an adjacent processing device.

2. The substrate delivery apparatus according to claim 1, wherein the take-out device takes out the substrate from the tank, in which a cassette in an inclined state and housing the plurality of the substrate is housed, and deliver the substrate to the processing device.

3. The substrate delivery apparatus according to claim 1 or 2, wherein the cart housing includes a positioning mechanism that positions the substrate transportation cart at a predetermined position.

4. The substrate delivery apparatus according to claim 3, wherein the positioning mechanism includes a separation mechanism that separates the tank from the substrate transportation cart at a position where the substrate can be taken out by the take-out device.

5. The substrate delivery apparatus according to ay one of claims 1 to 4, wherein the cart housing includes a drainage that drains liquid from the tank, and a liquid supply that supplies liquid in the tank.

6. The substrate delivery apparatus according to any one of claims 1 to 5 , wherein the take-out device includes a holder that holds the substrate,
the substrate delivery apparatus further comprising a washer that washes the holder.

7. The substrate delivery apparatus according to any one of claims 1 to 6, comprising an air blower that generates downflow from above the housing room and the take-out device.

8. A substrate delivery method, comprising:
housing a substrate transportation cart, in which a tank containing a plurality of substrates and liquid is loaded, in a cart housing having a housing room, and
taking out the substrate out from the tank loaded in the substrate transportation cart housed in the housing room by a take-out device and delivering the substrate to an adjacent processing device.
